# EUROPÄISCHE PATENTSCHRIFT

(11) **EP 0 880 182 B1**
(45) Veröffentlichungstag und Bekanntmachung des Hinweises auf die Patenterteilung: **26.03.2008**
(21) Anmeldenummer: 98810444.4
(22) Anmeldetag: 14.05.1998
(51) Int. Cl.: H01L 29/747

(54) **Beidseitig steuerbarer Thyristor**
Bidirectional controllable thyristor
Thyristor contrôlable bidirectionnel

(30) Priorität: 22.05.1997 DE 19721365
(43) Veröffentlichungstag der Anmeldung: 25.11.1998
(73) Patentinhaber: ABB Schweiz AG, 5400 Baden (CH)
(72) Erfinder: Thomas, Kenneth, Dr., 8200 Schaffhausen (CH); Streit, Peter, Dr., 8967 Widen (CH)
(74) Vertreter: ABB Patent Attorneys

(56) Entgegenhaltungen:
- DE-A- 4 439 012
- US-A- 4 063 277
- PATENT ABSTRACTS OF JAPAN vol. 6, no. 123 (E-117), 8. Juli 1982 (1982-07-08) & JP 57 049269 A (MITSUBISHI ELECTRIC CORP), 23. März 1982 (1982-03-23)

## Beschreibung

### Technisches Gebiet

Die Erfindung bezieht sich auf das Gebiet der Leistungshalbleiterbauelemente und betrifft einen beidseitig steuerbaren Thyristor nach dem Oberbegriff des ersten Anspruchs.

### Stand der Technik

Ein gattungsgemässer Thyristor wird beispielsweise in der Deutschen Patentanmeldung DE 44 39 012 A1 beschrieben. Es handelt sich dabei um einen beidseitig steuerbaren Thyristor, bei dem in einem Halbleitersubstrat zwei antiparallel geschaltete Thyristorstrukturen integriert sind. Die Thyristorstrukturen werden auf den Bauelementflächen durch je eine Trennregion mit vorzugsweise reduzierter Trägerlebensdauer entkoppelt. Eine Trennregion zwischen den Thyristorstrukturen ist hauptsächlich aus zwei Gründen notwendig: Zunächst sollen beim Zünden der einen Thyristorstruktur keine parasitären Strompfade zur anderen Thyristorstruktur entstehen, es soll aber auch beim Kommutieren keine Wechselwirkung zwischen den beiden Thyristorstrukturen auftreten. Die Lösung nach dem Stand der Technik vermag zwar bereits in vielen Fällen genügen, durch unerwünschte Migration von Ladungsträgern von einer schon gezündeten Thyristorstruktur zur anderen noch nicht gezündeten kann die sperrende Thyristorstruktur aber durch lokales, unkontrolliertes Zünden zerstört werden.

Aus JP 57-49269 ist ein Triac bekannt, bei dem von einer Gateelektrode aus zwei auf demselben Wafer antiparallel angeordnete Teilthyristoren angesteuert werden. Zur Verbesserung der Symmetrie des Gatetriggems und der Symmetrie der Eigenschaften der Stromumkehr werden in der Kathodenregion, welche sich auf derselben Seite wie die Gateelektrode befindet, Kurzschlussgebiete angeordnet, welche in der Nähe des Gates ein Gebiet höherer Dichte aufweisen und gatefern ein Gebiet mit niedrigerer Dichte, wobei in der Kathodenregion, welche auf der gegenüberliegenden Seite angeordnet ist, ebenfalls Kurzschlussgebiete mit einer niedrigeren Dichte als bei den Kurzschlussgebieten höherer Dichte auf der gegenüberliegenden Seite angeordnet sind.

### Darstellung der Erfindung

Es ist daher Aufgabe der Erfindung, einen beidseitig steuerbaren Thyristor anzugeben, der sich durch ein verbesserte Entkopplung zwischen den beiden Thyristorstrukturen auszeichnet. Insbesondere soll die sperrende Struktur nicht durch unerwünschte Migration von Ladungsträgern unkontrolliert gezündet werden können. Diese Aufgabe wird durch die Merkmale der unabhängigen Ansprüche gelöst.

Kern der Erfindung ist es, dass der Grad der Vershortung der Kathodenregion gegen die Trennregion hin zunimmt. Dies kann dadurch erreicht werden, dass die Dichte pro Flächeneinheit der Kurzschlussgebiete gegen die Trennregion hin einem Maximalwert zustrebt. Besonders günstig ist ausserdem die Verwendung einer linienförmigen, der Trennregion entlang verlaufenden, durchgehenden Kurzschlussregion.

Bei einem bevorzugten Ausführungsbeispiel erreicht man eine weitere verbesserte Entkopplung der beiden Thyristorstrukturen durch eine im wesentlichen hufeisenförmige Region, die im Bereich zwischen der zentralen Gateregionen und der benachbarten Anodenregion angeordnet ist. Die hufeisenförmige Region trägt ebenfalls dazu bei, dass die in den Gate-Kathodenkreis eingestossenen Ladungsträger keinem parasitären Strompfad zwischen der Gateregion und der Anodenregion der anderen Thyristorstruktur derselben Hauptfläche folgen können. Die hufeisenförmige Region wird mit Vorteil durch Ätzen oder durch in diesem Bereich maskierte Implantation von Dotierstoffen erzeugt.

Eine weitere Verbesserung der Trennung zwischen den Thyristorstrukturen eines erfindungemässen Thyristors erreicht man auch dadurch, dass die zentrale Gateregion lateral in die jeweilige Kathodenregion reicht und auf den entsprechenden Anodenemitter ausgerichtet ist. Zudem soll zwischen der Trennregion und einer etwaigen verstärkenden Gatefingerstruktur ein Winkel aufgespannt werden, der grösser Null ist und insbesondere 45° beträgt. Die diametral verlaufende Trennregion soll eine Breite von ca. 10 Diffusionslängen der Minoritätsladungsträger aufweisen.

Weitere vorteilhafte Ausführungsformen ergeben sich aus den entsprechenden abhängigen Ansprüchen.

### Kurze Beschreibung der Zeichnungen

Nachfolgend wird die Erfindung anhand von Ausführungsbeispielen im Zusammenhang mit den Zeichnungen näher erläutert.

Es zeigen:
- Fig. 1: Einen erfindungsgemässen Thyristor von oben.
- Fig. 2: Einen erfindungsgemässen Thyristor von unten.
- Fig. 3: Einen erfindungsgemässen Thyristor im Schnitt entlang der Linie A-A der Figur 1.
- Fig. 4: Einen erfindungsgemässen Thyristor im Schnitt entlang der Linie B-B der Figur 1.

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

### Wege zur Ausführung der Erfindung

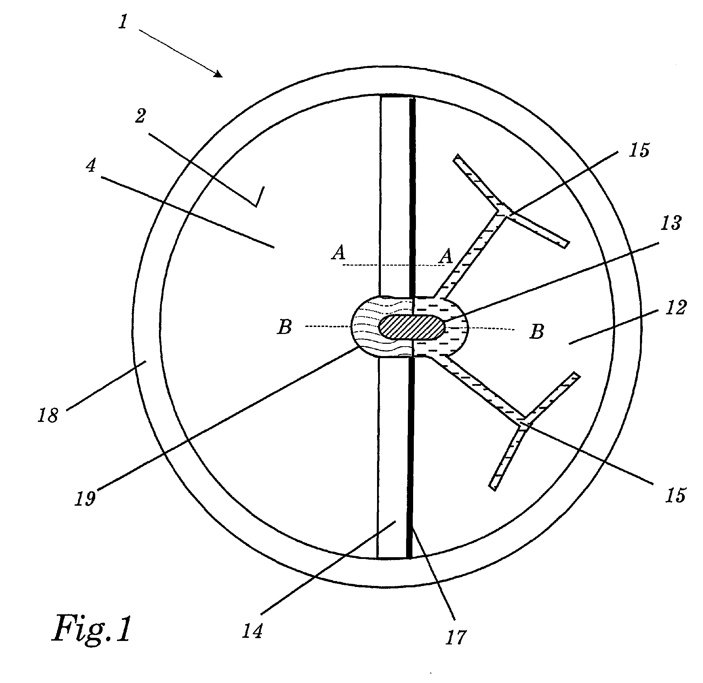

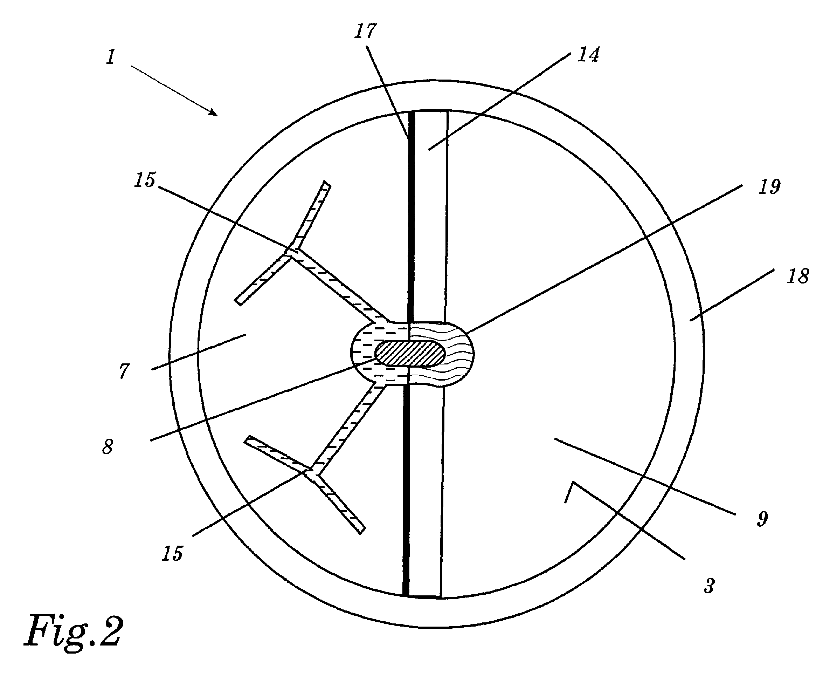

Figur 1 zeigt einen erfindungsgemässen Thyristor 1 von oben. In einem Halbleiterkörper sind zwischen einer ersten, oberen Hauptfläche 2 und einer zweiten, unteren Hauptfläche 3 (in Figur 2 ersichtlich) zwei Thyristorstrukturen angeordnet. Von oben ersichtlich sind die Anodenregion 4 der ersten Thyristorstruktur, die Kathodenregion 12 der zweiten Thyristorstruktur, die zentrale Gateregion 13 der zweiten Thyristorstruktur, ein Randabschlussgebiet 18 und eine verstärkende Gatefingerstruktur 15. Zwischen den Thyristorstrukturen ist eine Trennregion 14 vorgesehen. Diese Trennregion 14 ist in einen das zentrale Gate 13 umgebenden Bereich hufeisenförmig und besonders hochohmig ausgebildet. Im Bereich der zweiten Kathodenregion 12 sind Kurzschlussgebiete 16 vorgesehen (nur in den Schnittbildern ersichtlich). Um eine unerwünschte Migration von Ladungsträgern aus einer bereits gezündeten Thyristorstruktur zur anderen nicht gezündeten zu vermeiden - dies könnte ein unkontrolliertes Zünden der noch nicht gezündeten Thyristorstruktur hervorrufen -, nimmt die Dichte der Kurzschlussgebiete 16 gegen die Trennregion 14 hin zu. Sie erreicht an der Grenze zur Trennregion 14 einen Maximalwert, der mit Vorteil durch eine linienförmige, entlang der Trennregion 14 verlaufende Kurzschlussregion 17 gebildet wird.

Figur 2 zeigt den Thyristor von unten. Ersichtlich sind auf der zweiten Hauptfläche 3 die Anodenregion 9 der zweiten Thyristorstruktur, die Kathodenregion 7 der ersten Thyristorstruktur, die zentrale Gateregion 8 der ersten Thyristorstruktur, ein Randabschlussgebiet 18 und eine verstärkende Gatefingerstruktur 15. Zwischen den Thyristorstrukturen ist ebenfalls eine Trennregion 14 vorgesehen. Diese Trennregion ist ebenfalls um das zentrale Gate 8 herum hufeisenförmig und besonders hochohmig ausgestaltet. In der Kathodenregion 7 sind ebenfalls Kurzschlussregionen 16 vorgesehen (nur in den Schnittbildern ersichtlich). Um eine unerwünschte Migration von Ladungsträgern aus einer bereits gezündeten Thyristorstruktur zur anderen nicht gezündeten zu vermeiden - dies könnte ein unkontrolliertes Zünden der noch nicht gezündeten Thyristorstruktur hervorrufen -, nimmt die Dichte der Kurzschlussgebiete 16 auch hier gegen die Trennregion 14 hin zu. Sie erreicht an der Grenze zur Trennregion 14 einen Maximalwert, der ebenfalls mit Vorteil durch eine linienförmige, entlang der Trennregion 14 verlaufende Kurzschlussregion 17 gebildet wird. Die Trennregion 14 verläuft diametral auf beiden Hauptflächen 2 und 3 und weist eine Breite von ca. 10 Diffusionslängen der Minoritätsladungsträger auf.

Die Figuren 1 und 2 zeigen ausserdem die verstärkende Gatefingerstruktur 15. Diese verstärkende Gatefingerstruktur 15 weist im Gegensatz zum eingangs genannten Stand der Technik keinen Teil auf, der entlang der Trennregion 14 verläuft; sondern zwischen der Trennregion 14 und den Fingern 15 der verstärkenden Gatefingerstruktur wird ein Winkel aufgespannt, der zumindest grösser Null ist und vorzugsweise 45° beträgt. Dadurch gewährleistet die Fingerstruktur 15 einerseits eine effiziente Zündreaktion, verhindert aber andererseits ein unerwünschtes Zünden im Bereich zwischen den beiden Thyristorstrukturen.

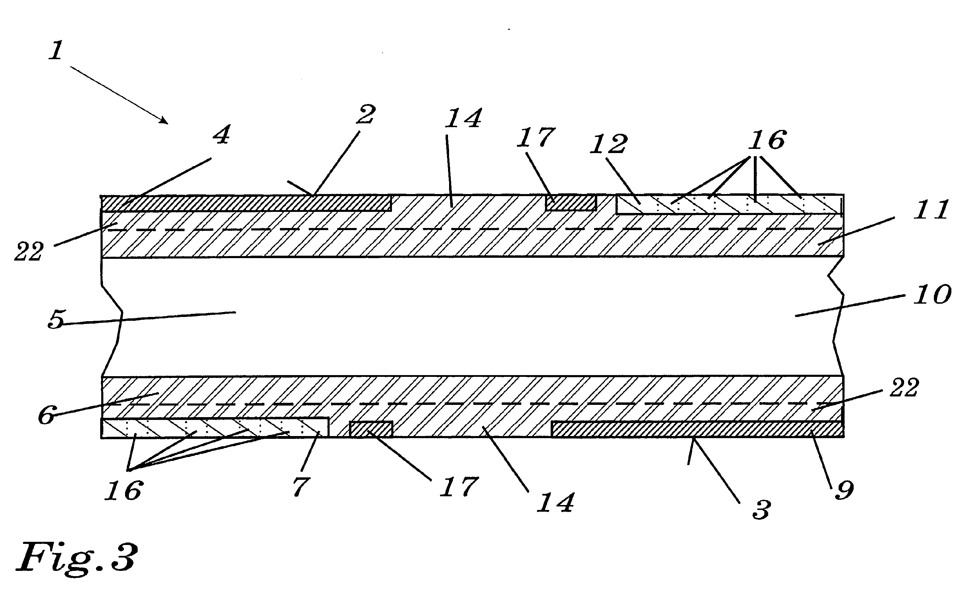

Figur 3 zeigt einen Ausschnitt aus einem erfindungsgemässen Thyristor entlang der Linien A-A im Schnitt. Deutlich zu erkennen ist, wie auf beiden Hauptflächen 2 und 3 entlang der Trennregion 14 eine Kurzschlussregion 17 angeordnet ist. Die Kurzschlussregion 17 kann wie dargestellt aus Herstellungsgründen von der benachbarten Kathodenregion 12 oder 7 leicht beabstandet sein. Die Flächendichte, d.h. die Anzahl der Kurzschlussregionen 16 pro Flächeneinheit nimmt innerhalb der entsprechenden Kathodenregion 7 oder 12 gegen die durchgehende, linienförmige Kurzschlussregion 17 zu. Die Kurzschlussgebiete 16 und die Kurzschlussregion 17 schliessen die erste und zweite p-Basis 6, 11 durch die erste bzw. zweite Kathodenregion 7, 12 hindurch mit einer die Kathodenregion überdeckenden, der Übersicht halber nicht dargestellten Metallisierung kurz. Die höhere Dichte von Kurzschlussgebieten 16 gegen die Trennregion hin und insbesondere auch die durchgehende, linienförmige Kurzschlussregion 17 gewährleisten, dass beim Ausschalten Ladungsträger genügend schnell ausgeräumt werden und ein unkontrolliertes, zur Zerstörung führendes Zünden vermieden werden kann. Somit fliessen etwaige Ladungsträger nicht über die Kathodenregion sondern über die Kurzschlüsse ab. Damit veranlassen sie auch kein unkontrolliertes Zünden.

Die p-Basen 6 und 11 sind im übrigen als durchgehende Schichten dimensioniert, in die höher dotierte Anodenemitterregionen 4, 9 eindiffundiert sind. Die Trennregionen 14 werden beiderseits durch an die Oberfläche tretende Teile der p-Basen gebildet.

Aus Figur 1 und 2 ist ausserdem die hufeisenförmige Region 19 der Trennregion 14 ersichtlich, die die zentralen Gateregion 8,13 umgibt. Die Öffnung des Hufeisen ist der ersten bzw. der zweiten Kathodenregion zugewandt. Die Region 19 verstärkt die Trennwirkung zwischen den beiden Thyristorstrukturen und verhindert, dass die in den Gate-Kathodenkreis eingestossenen Ladungsträger einen parasitären Strompfad zwischen Gatekontakt und dem Anodenbereich der anderen Thyristorstruktur derselben Hauptfläche befolgen können. Der höhere Widerstand kann durch Ätzen eines bestehenden Dotierungsprofils oder durch selektive, im Bereich der Region 19 maskierte Implantation geeigneter Dotierstoffe erreicht werden.

Die Form der zentralen Gateregionen 8 und 13 ist länglich und in die Kathodenregionen 7 und 12 hineingestreckt. Das der jeweiligen Kathodenregion am nächsten liegende Ende der zentralen Gateregionen 8 und 13 ist genau oberhalb der Anodenregionen 4 und 9 derselben Thyristorstruktur angeordnet. Diese genaue Justierung trägt ebenfalls zur verbesserten Entkopplung der beiden Thyristorstrukturen bei und gewährleistet insbesondere reproduzierbare Bauelementeigenschaften.

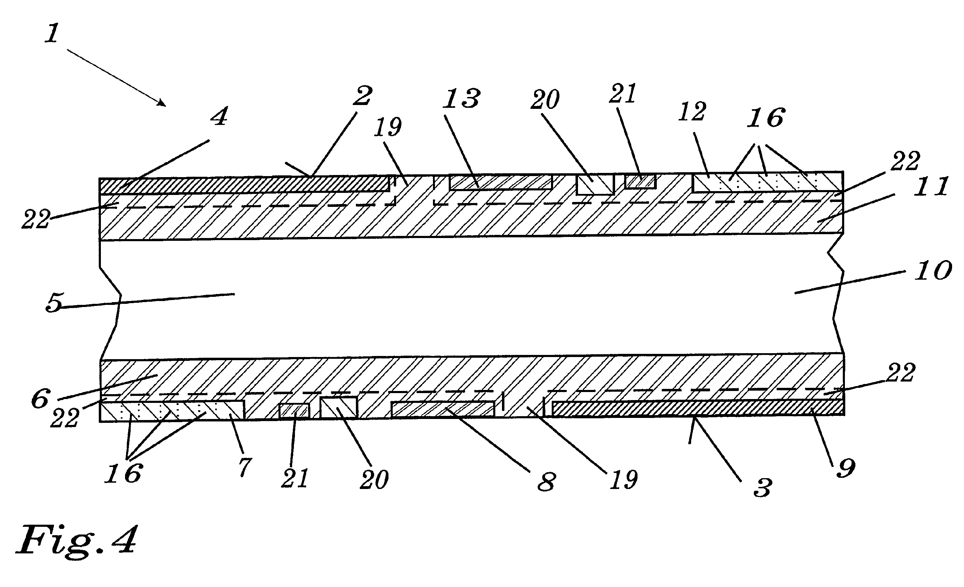

Figur 4 zeigt einen Schnitt entlang der Linie B-B der Figur 1. Deutlich ist zu sehen, wie zwischen den zentralen Gateregionen 13 und 8 und den benachbarten Anodenregion 4 und 9 die p-Basis an die Oberfläche dringt und die hufeisenförmige Trennregion 19 bildet. Diese ist besonders hochohmig ausgebildet, indem eine die Leitfähigkeit der p-Basis 6 bzw. 11 im wesentlichen bestimmende Zusatzdotierung 22, die ansonsten ganzflächig ausgebildet ist (siehe Figur 3) in diesem Bereich weggelassen wird. Dies kann durch Ätzen eines bestehenden Dotierungsprofils oder durch eine selektive, im gewünschten Bereich maskierte Implantation der p-dotierten Schicht 22 erfolgen. Am der Trennregion 19 gegenüberliegenden Ende der zentralen Gateregionen 13 und 8 ist eine n-dotierte Hilfskathode 20 und eine p+ dotierte Kontaktregion 21 vorgesehen. Daran anschliessend folgt die Kathodenregion 12 mit den Kurzschlussgebieten 16, deren Dichte wie gesagt gegen die Mitte des Bauelements zunimmt.

Insgesamt ergibt sich ein bidirektional leitender Thyristor, dessen Entkopplung zwischen den beiden Thyristorstrukturen stark verbessert ist und somit in jeder Betriebssituation sicher betrieben werden kann.

### Bezugszeichenliste

- 1: Thyristor
- 2: erste Hauptfläche
- 3: zweite Hauptfläche
- 4: erste Anodenregion
- 5: erste n-Basis
- 6: erste p-Basis
- 7: erste Kathodenregion
- 8: erste zentrale Gateregion
- 9: zweite Anodenregion
- 10: zweite n-Basis
- 11: zweite p-Basis
- 12: zweite Kathodenregion
- 13: zweite zentrale Gateregion
- 14: Trennregion
- 15: Gatefinger
- 16: Kurzschlussgebiete
- 17: Kurzschlussregion
- 18: Randabschluss
- 19: hufeisenförmige Region
- 20: Hilfskathode
- 21: Kontaktregion
- 22: p-Gebiet

## Patentansprüche

1. Beidseitig steuerbarer Thyristor (1) umfassend in einem Halbleiterkörper
(a) zwischen einer ersten Hauptfläche (2) und einer der ersten Hauptfläche (2) gegenüberliegenden zweiten Hauptfläche (3) eine erste Thyristorstruktur mit einer ersten Anodenregion (4), einer ersten n-Basis (5), einer ersten p-Basis (6), einer ersten Kathodenregion (7) und einer ersten, zentralen Gateregion (8) und antiparallel dazu eine zweite Thyristorstruktur mit einer zweiten Anodenregion (9), einer zweiten n-Basis (10), einer zweiten p-Basis (11), einer zweiten Kathodenregion (12) und einer zweiten, zentralen Gateregion (13), wobei die erste Anodenregion (4), die zweite Kathodenregion (12) und die zweite Gateregion (13) der ersten Hauptfläche (2) und die zweite Anodenregion (9), die erste Kathodenregion (7) und die erste Gateregion (8) der zweiten Hauptfläche (3) zugeordnet sind;
(b) auf beiden Hauptflächen (2, 3) je eine Trennregion (14), die zwischen den beiden Thyristorstrukturen zwischen der ersten Anodenregion (4) und der zweiten Kathodenregion (12) und zwischen der zweiten Anodenregion (9) und der ersten Kathodenregion (7) angeordnet ist; sowie
(c) Kurzschlussgebiete (16), die die erste und zweite p-Basis (6,11) durch die erste bzw. zweite Kathodenregion (7, 12) hindurch mit einer die Kathodenregionen überdeckenden Metallisierung kurzschliessen;
**dadurch gekennzeichnet, dass** eine Dichte pro Flächeneinheit der Kurzschlussgebiete (16) gegen die Trennregion (14) hin zunimmt und unmittelbar benachbart zur Trennregion (14) einen Maximalwert annimmt.

2. Thyristor nach Anspruch 1, **dadurch gekennzeichnet, dass** die Kurzschlussgebiete (16) eine linienförmige, entlang der Trennregionen (14), zwischen den Kathodenregionen (7, 12) und den Trennregionen (14) verlaufende, durchgehende Kurzschlussregion (17) umfassen.

3. Thyristor nach einem der Ansprüche 1 oder 2, **dadurch gekennzeichnet, dass** um die erste und die zweite zentrale Gateregion (8, 13) zwischen den Gateregionen und den benachbarten Anodenregionen eine im wesentlichen hufeisenförmig ausgebildete, insbesondere besonders hochohmige Region (19) vorgesehen ist, wobei die Öffnung des Hufeisens auf der ersten Hauptfläche (2) der zweiten Kathodenregion (12) zugewandt ist und die Öffnung des Hufeisens auf der zweiten Hauptfläche (3) der ersten Kathodenregion (7) zugewandt ist.

4. Thyristor nach einem der vorstehenden Ansprüche, **dadurch gekennzeichnet, dass** jede Thyristorstruktur eine verstärkende, von der entsprechende zentralen Gateregion (8, 13) ausgehende Gatefingerstruktur (15) aufweist, die auf der ersten bzw. zweiten Hauptfläche (2, 3) in die entsprechende Kathodenregion (7, 12) integriert ist, derart dass zwischen den Trennregionen (14) und den Gatefingerstrukturen (15) ein Winkel aufgespannt wird, der grösser Null ist und insbesondere ungefähr 45° beträgt.

5. Thyristor nach einem der vorstehenden Ansprüche, **dadurch gekennzeichnet, dass** der Rand der ersten zentralen Gateregion (8), welcher der ersten Kathodenregion (7) zugewandt ist, auf den Rand der ersten Anodenregion (4) ausgerichtet ist, welcher der zweiten zentralen Gateregion (13) zugewandt ist, und dass
der Rand der zweiten zentralen Gateregion (13), welcher der zweiten Kathodenregion (12) zugewandt ist, auf den Rand der zweiten Anodenregion (9) ausgerichtet ist, welcher der ersten zentralen Gateregion (8) zugewandt ist.

6. Thyristor nach einem der vorstehenden Ansprüche, **dadurch gekennzeichnet, dass** die Trennregionen (14) diametral verlaufen und eine Breite von ungefähr 10 Diffusionslängen der Minoritätsladungsträger aufweisen.

7. Verfahren zur Herstellung eines Thyristors nach Anspruch 3, **dadurch gekennzeichnet, dass** die hufeisenförmige Region (19) durch Ätzen hergestellt wird.

8. Verfahren zur Herstellung eines Thyristors nach Anspruch 3, **dadurch gekennzeichnet, dass** die hufeisenförmige Region (19) durch maskierte Implantation eines Teils der die p-Basis bildenden Dotierstoffe hergestellt wird.

## Claims

1. Bidirectionally controllable thyristor (1) comprising in a semiconductor body
(a) between a first main surface (2) and a second main surface (3) on the opposite side from the first main surface (2), a first thyristor structure having a first anode region (4), a first n-type base (5), a first p-type base (6), a first cathode region (7) and a first central gate region (8), and anti-parallel thereto, a second thyristor structure having a second anode region (9), a second n-type base (10), a second p-type base (11), a second cathode region (12) and a second central gate region (13), with the first anode region (4), the second cathode region (12) and the second gate region (13) being assigned to the first main surface (2), and the second anode region (9), the first cathode region (7) and the first gate region (8) being assigned to the second main surface (3);
(b) on the two main surface (2, 3) a respective isolation region (14), which is arranged between the two thyristor structures between the first anode region (4) and the second cathode region (12), and between the second anode region (9) and the first cathode region (7); and
(c) short-circuit regions (16), which short-circuit the first and second p-type base (6, 11) through the first and second cathode region (7, 12) respectively by a metallization that covers the cathode regions;
**characterized in that** a density per unit area of the short-circuit regions (16) increases towards the isolation region (14) and assumes a maximum value immediately adjacent to the isolation region (14).

2. Thyristor according to Claim 1, **characterized in that** the short-circuit regions (16) comprise a linear, continuous short-circuit region (17) running along the isolation regions (14) between the cathode regions (7, 12) and the isolation regions (14).

3. Thyristor according to either of Claims 1 or 2, **characterized in that** a region (19), which is formed substantially in a horseshoe-shape and, in particular, has an especially high resistance, is provided around the first and the second central gate region (8, 13) between the gate regions and the adjacent anode region, with the mouth of the horseshoe on the first main surface (2) facing the second cathode region (12), and the mouth of the horseshoe on the second main surface (3) facing the first cathode region (7).

4. Thyristor according to any of the previous claims, **characterized in that** each thyristor structure has an amplifying gate-finger structure (15) emanating from the corresponding central gate region (8, 13), said gate-finger structure being integrated on the first or second main surface (2, 3) in the respective cathode region (7, 12) in such a way that the gatefinger structures (15) make an angle with the isolation regions (14) that is greater than zero and, in particular, equals approximately 45°.

5. Thyristor according to any of the previous claims, **characterized in that** the edge of the first central gate region (8) that faces the first cathode region (7) is aligned with the edge of the first anode region (4) that faces the second central gate region (13), and that the edge of the second central gate region (13) that faces the second cathode region (12) is aligned with the edge of the second anode region (9) that faces the first central gate region (8).

6. Thyristor according to any of the previous claims, **characterized in that** the isolation regions (14) run diametrically and have a width equal to approximately 10 diffusion lengths of the minority charge carriers.

7. Method for fabricating a thyristor according to Claim 3, **characterized in that** the horseshoe-shaped region (19) is fabricated by etching.

8. Method for fabricating a thyristor according to Claim 3, **characterized in that** the horseshoe-shaped region (19) is fabricated by masked implantation of some of the dopants forming the p-type base.

## Revendications

1. Thyristor contrôlable bidirectionnel (1), comportant dans un corps à semi-conducteurs
(a) entre une première surface principale (2) et une deuxième surface principale (3) opposée à la première surface principale (2), une première structure de thyristor comportant une première zone anodique (4), une première base n (5), une première base p (6), une première zone cathodique (7) et une première zone de grille centrale (8) et antiparallèlement par rapport à ceci une deuxième structure de thyristor comportant une deuxième zone anodique (9), une deuxième base n (10), une deuxième base p (11), une deuxième zone cathodique (12) et une deuxième zone de grille centrale (13), la première zone anodique (4), la deuxième zone cathodique (12) et la deuxième zone de grille (13) de la première surface principale (2) et la deuxième zone anodique (9), la première zone cathodique (7) et la première zone de grille (8) étant associées à la deuxième surface principale (3) ;
b) sur les deux surfaces principales (2, 3), à chaque fois une zone de séparation (14) qui est disposée entre les deux structures de thyristor entre la première zone anodique (4) et la deuxième zone cathodique (12) et entre la deuxième zone anodique (9) et la première zone cathodique (7) ; ainsi que
c) des zones de court-circuit (6) qui court-circuitent la première et la deuxième base p (6, 11) à travers la première ou deuxième zone cathodique (7, 12) par une métallisation recouvrant les zones cathodiques ;
**caractérisé en ce qu'**une densité par unité surfacique des secteurs de court-circuit (16) augmente en direction de la zone de séparation (14) et prend une valeur maximale directement à proximité de la zone de séparation (14).

2. Thyristor selon la revendication 1, **caractérisé en ce que** les secteurs de court-circuit (16) comprennent une zone de court-circuit (17) continue linéaire s'étendant le long des zones de séparation (14) entre les zones cathodiques (7) et les zones de séparation (14).

3. Thyristor selon une des revendications 1 ou 2, **caractérisé en ce qu'**autour de la première et de la deuxième zone de grille centrale (8, 13), entre les zones de grille et les zones anodiques voisines, il est prévu une zone très fortement ohmique réalisée sensiblement en forme de fer à cheval (19), l'ouverture du fer à cheval sur la première surface principale (2) étant tournée vers la deuxième zone cathodique (12) et l'ouverture du fer à cheval sur la deuxième surface principale (2) étant tournée vers la première zone cathodique (7).

4. Thyristor selon une des revendications précédentes, **caractérisé en ce que** chaque structure de thyristor présente une structure à doigts de grille de renfort (15) partant de la zone de grille centrale correspondante (8, 13) et qui est intégrée sur la première ou la deuxième surface principale (2, 3) dans la zone cathodique correspondante (7, 12) de manière à ce qu'il soit sous-tendu entre les zones de séparation (14) et les structures à doigts de grille un angle qui est supérieur à zéro et est notamment d'environ 45°.

5. Thyristor selon une des revendications précédentes, **caractérisé en ce que** le bord de la première zone de grille centrale (8) qui est tourné vers la première zone cathodique (7) est orienté vers le bord de la première zone anodique (4) qui est tourné vers la deuxième zone de grille centrale (13) et que
le bord de la deuxième zone de grille centrale (8) qui est tourné vers la deuxième zone cathodique (12) est orienté vers le bord de la deuxième zone anodique (9) qui est tourné vers la première zone de grille centrale (8).

6. Thyristor selon une des revendications précédentes, **caractérisé en ce que** les zones de séparation (14) s'étendent diamétralement et présentent une largeur représentant environ 10 longueurs de diffusion des porteurs de charge minoritaires.

7. Procédé de fabrication d'un thyristor selon la revendication 3, **caractérisé en ce que** la zone en forme de fer à cheval (19) est réalisée par attaque.

8. Procédé de fabrication d'un thyristor selon la revendication 3, **caractérisé en ce que** la zone en forme de fer à cheval (19) est fabriquée par implantation masquée d'une partie des substances dopantes constituant la base p.
